(19) Europäisches Patentamt
European Patent Office
Office européen des brevets

(11) Veröffentlichungsnummer : **0 312 950 B1**

(12) # EUROPÄISCHE PATENTSCHRIFT

(45) Veröffentlichungstag der Patentschrift : **04.01.95 Patentblatt 95/01**

(51) Int. Cl.$^6$ : **G03F 7/09**

(21) Anmeldenummer : **88117219.1**

(22) Anmeldetag : **17.10.88**

(54) **Positiv arbeitendes lichtempfindliches Gemisch, enthaltend einen Farbstoff, und daraus hergestelltes positiv arbeitendes lichtempfindliches Aufzeichnungsmaterial.**

(30) Priorität : **23.10.87 DE 3735852**

(43) Veröffentlichungstag der Anmeldung : **26.04.89 Patentblatt 89/17**

(45) Bekanntmachung des Hinweises auf die Patenterteilung : **04.01.95 Patentblatt 95/01**

(84) Benannte Vertragsstaaten : **AT BE CH DE FR GB IT LI NL**

(56) Entgegenhaltungen :
**EP-A- 0 231 522**
**PATENT ABSTRACTS OF JAPAN, Band 10, Nr. 271 (P-497)[2327], 16. September 1986, Seite 18 P 497; & JP-A-61 93 445**

(73) Patentinhaber : **HOECHST AKTIENGESELLSCHAFT**
**D-65926 Frankfurt (DE)**

(72) Erfinder : **Merrem, Hans-Joachim, Dr. Dipl.-Chem.**
**Donnerbergstrasse 6**
**D-6104 Seeheim-Jugenheim (DE)**
Erfinder : **Buhr, Gerhard, Dr. Dipl.-Chem.**
**Am Erdbeerstein 28**
**D-6240 Königstein 4 (DE)**
Erfinder : **Lenz, Rüdiger, Dr. Dipl.-Chem.**
**Geisenheimer Strasse 88**
**D-6000 Frankfurt (Main) 71 (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 312 950 B1

## Beschreibung

Positiv arbeitendes lichtempfindliches Gemisch, enthaltend einen Farbstoff, und daraus hergestelltes positiv arbeitendes lichtempfindliches Aufzeichnungsmaterial

Die Erfindung betrifft ein positiv arbeitendes lichtempfindliches Gemisch, enthaltend eine lichtempfindliche Verbindung, ein wasserunlösliches, in wäßrig-alkalischer Lösung aber lösliches bzw. quellbares Bindemittel sowie einen Farbstoff.

Lichtempfindliche Gemische, die als Bindemittel einen Novolak oder ein Polyvinylphenol und als lichtempfindliche Verbindung z.B. ein o-Chinondiazid enthalten, werden seit langem bei der Herstellung von hochauflösenden Strukturen in der Fertigung von Halbleiterbauelementen eingesetzt. Aufgrund der zunehmenden Miniaturisierung der Funktionselemente werden immer höhere Anforderungen an das optische Auflösungsvermögen dieser lichtempfindlichen Gemische gestellt. Probleme sind insbesondere dann zu erwarten, wenn die Strukturierung in der Nähe der Auflösungsgrenze der optischen Belichtungssysteme erfolgt. In diesen Grenzbereichen wird die Auflösung vor allem durch optische Störeffekte, wie Interferenzerscheinungen und unerwünschte Streulichtreflexionen an der Substratoberfläche beeinflußt. Derartige Effekte können z.T. durch eine Erhöhung der nicht ausbleichbaren Absorption der lichtempfindlichen Gemische vermieden werden. Dies geschieht beispielsweise durch Zugabe von im aktinischen Bereich absorbierenden Substanzen zu dem lichtempfindlichen Gemisch.

Der Zusatz von absorbierenden Substanzen zu lichtempfindlichen Gemischen ist seit langem bekannt. Beispielsweise wird in der EP-A-0 026 088 beschrieben, daß durch Zusatz von Farbstoffen zu negativ arbeitenden Photoresists eine Verbesserung der bildmäßig erzeugten Strukturen erreicht werden kann.

Der Zusatz von Farbstoffen zu positiv arbeitenden Photoresists ist erstmals von A.R. Neureuther und F.H. Dill ("Photoresist Modeling und Device Fabrication Applications", Proceedings of Symposium on Optical and Acoustical Micro-Electronics, Polytechnic Institute of New York, 16.-18.04.1974, Seiten 223-249) beschrieben worden. Danach wird durch Farbstoffzusatz vor allem die auf Interferenzeffekten beruhende Beeinträchtigung der optischen Auflösung reduziert.

Von H.L. Stover, M. Nagler, I.I. Bol und V. Miller wird in "Submicron Optical Lithography: I-line Lens and Photoresist Technology" (SPIE Proceedings, Band 470, Seiten 22-33 (1984)) beschrieben, daß die optische Auflösung durch Zusatz eines absorbierenden Farbstoffes, der im Bereich der Belichtungswellenlänge von $\lambda = 436$ nm absorbiert, deutlich verbessert wird, andererseits die Belichtungszeit zur Erzeugung von bildmäßigen Strukturen im Vergleich zu einem System ohne diese absorbierende Substanz deutlich verlängert werden muß.

In der PCT WO 86/01914 wird ein Verfahren beschrieben, bei dem ebenfalls die Erzeugung von Photoresiststrukturen durch Verwendung eines nicht ausbleichbaren, lichtabsorbierenden Zusatzes verbessert wird. Auch in diesem Fall wird darauf hingewiesen, daß die Belichtungszeit im Vergleich zu einem Photoresist ohne Zusatz um etwa 50-150 % verlängert werden muß. Als besonders bevorzugte Farbstoffe werden Cumarinderivate genannt.

Ein Cumarinderivat wird ebenfalls von I.I. Bol in "High-Resolution Optical Lithography Using Dyed Single-Layer Resist" (Proceedings Kodak Microelectronics Seminar 1984, Seiten 19-22) beschrieben und die signifikante Verbesserung der photolithographischen Eigenschaften des Photoresists bestätigt.

Der Einfluß von im aktinischen Bereich absorbierenden Substanzen auf die photolithographischen Eigenschaften von positiv arbeitenden Photoresists wird von A.V. Brown und W.H. Arnold in "Optimization of Resist Optical Density for High Resolution Lithographie on Reflective Surfaces" (SPIE Proceeding, Band 539, Seiten 259-266 (1985)) und M.P.C. Watts, D. DeBruin und W.H. Arnold in "The Reduction of Reflective Notching Using Dyed Resists" (Proceedings of Seventh International Technical Conference on Photopolymers, Ellenville, N.Y., Oktober 1985, Seiten 285-296) ausführlich abgehandelt. Nach diesen Untersuchungen wird durch Zusatz von im aktinischen Bereich absorbierenden Substanzen die Löslichkeit der Photoresistgemische in den wäßrig-alkalischen Entwicklern herabgesetzt und damit die Lichtempfindlichkeit dieser Photolacke deutlich vermindert.

T.R. Pampalone und K.A. Kuyan beschreiben in "Improving Linewidth Control over Reflective Surfaces Using Heavily Dyed Resists" (Journal of the Electochemical Society, Band 133, Heft 1, Seiten 192-196 (1986)) den Einfluß von hohen Konzentrationen an absorbierenden Substanzen im Photoresist. Nach diesen Untersuchungen werden besonders gute Ergebnisse mit Photoresists erzielt, die eine besonders hohe Absorption im aktinischen Bereich aufweisen. Auch in diesem Fall zeigt sich, daß durch Zusatz der absorbierenden Verbindung die Lichtempfindlichkeit deutlich, d.h. bis um den Faktor fünf oder mehr zurückgeht.

In der US-A 4,575,480 werden ebenfalls Photoresistformulierungen beschrieben, die im aktinischen Bereich absorbierende Substanzen enthalten. Die genannten Verbindungen zeichnen sich durch geringe Neigung zum Sublimieren sowie durch hohe Absorption im aktinischen Bereich aus. Von Nachteil ist die - je nach Konzentration des Zusatzes -zum Teil deutlich reduzierte Lichtempfindlichkeit der Photoresistformulierungen.

In analoger Weise werden in den japanischen Patentanmeldungen 86-159626/25, 86-165777/26, 86-174465/27 und 86-174466/27 Photoresistformulierungen beschrieben, die ebenfalls nicht ausbleichbare und nicht sublimierbare absorbierende Substanzen enthalten. In allen Fällen ist jedoch die Löslichkeit der belichteten Resistanteile in den Entwicklerlösungen deutlich reduziert.

Photoresists, die neben einem im aktinischen Bereich ab sorbierenden Farbstoff zusätzlich eine löslichkeitssteigernde Komponente, insbesondere Trihydroxybenzophenon enthalten, werden in der US-A 4,626,492 genannt. Das Trihydroxybenzophenon wird in Mengen von 12,8 bis 13,1 Gewichtsprozenten zugesetzt, wodurch sich allerdings die thermische Beständigkeit des Photoresists deutlich verschlechtert. Außerdem wird eine Verschlechterung der Verarbeitungsbreite des Resists beobachtet, da die Entwicklungsrate stark von der Vortrocknungstemperatur des Resistfilms abhängt.

Aufgabe der Erfindung war es daher, ein positiv arbeitendes lichtempfindliches Gemisch bereitzustellen, enthaltend einen nicht ausbleichbaren, im aktinischen Bereich absorbierenden Farbstoff, der folgende Eigenschaften zeigen bzw. bewirken soll:

- gute Löslichkeit im Lösemittel bzw. Lösemittelgemisch des lichtempfindlichen Gemischs, so daß die Bildung von unerwünschten Ausfällungen bei Lagerung des Gemischs, insbesondere bei tiefen Temperaturen, nicht eintritt,
- gute thermische Beständigkeit und geringe Neigung zum Sublimieren, um einerseits eine - auch bei hohen Temperaturen - konstante Absorption der aktinischen Strahlung zu gewährleisten und andererseits die Kontamination von Prozeßgeräten möglichst gering zu halten,
- hohe Absorption im Bereich der aktinischen Strahlung, um in effizienter Weise unerwünschte optische Effekte zu minimieren.

Gelöst wird die Aufgabe durch Bereitstellen eines positiv arbeitenden lichtempfindlichen Gemischs, enthaltend eine lichtempfindliche Verbindung, ein wasserunlösliches, in wäßrig-alkalischer Lösung aber lösliches bzw. quellbares Bindemittel sowie einen Farbstoff, dadurch gekennzeichnet, daß der Farbstoff eine im aktinischen Bereich absorbierende, nicht ausbleichbare Verbindung der allgemeinen Formel I

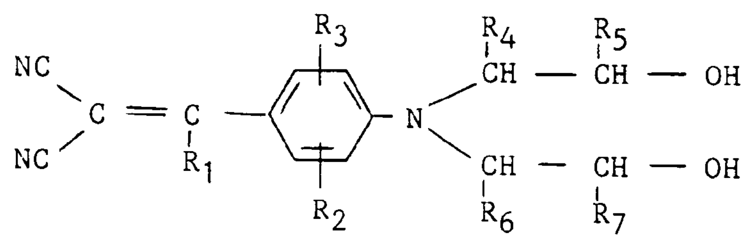

(I)

ist, worin

| | |
|---|---|
| $R_1$ | Wasserstoff, Alkyl, Aryl, Alkoxy oder Nitrilo, |
| $R_2$ und $R_3$ | gleich oder verschieden sind und Wasserstoff, Hydroxy, Alkyl, Aryl, Alkoxy, Aryloxy, Nitrilo, Amino, Alkylamino oder Halogen, |
| $R_4$, $R_5$, $R_5$ und $R_7$ | gleich oder verschieden sind und Wasserstoff, Hydroxy, Alkyl, Aryl, Alkoxy, Aryloxy, Amino, Alkylamino oder Halogen |

bedeuten.

Verbindungen, die unter die oben genannte allgemeine Formel I fallen, zeichnen sich dadurch aus, daß sie die An forderungen hoher Absorption im aktinischen Bereich in besonderem Maße erfüllen.

Als besonders überraschende Eigenschaften, die das erfindungsgemäße lichtempfindliche Gemisch neben den schon in der Aufgabenstellung genannten aufweist, sind zu nennen:

- eine höhere Lichtempfindlichkeit des erfindungsgemäßen lichtempfindlichen Gemischs im Vergleich zu lichtempfindlichen Gemischen, die andere, nicht beanspruchte Farbstoffe, die ebenso im aktinischen Bereich absorbieren, enthalten.
- keine oder nur geringe Reduzierung der Lichtempfindlichkeit des erfindungsgemäß lichtempfindlichen Gemischs im Vergleich zu lichtempfindlichen Gemischen, die keine bzw. andere Farbstoffe enthalten.

Insbesondere werden solche im aktinischen Bereich absorbierende Farbstoffe bevorzugt, die entsprechend der allgemeinen Formel I für

| | |
|---|---|
| $R_1$ | Wasserstoff, $(C_1-C_3)$Alkyl oder Phenyl, |
| $R_2$ und $R_3$ | Wasserstoff, Hydroxy, $(C_1-C_3)$Alkyl, $(C_6-C_{10})$-Aryl, $(C_1-C_3)$Alkoxy, Amino, $(C_1-C_3)$Alkylamino, Halogen, insbesondere Chlor oder Brom, und für |
| $R_4$, $R_5$, $R_5$ und $R_7$ | Wasserstoff, $(C_1-C_3)$Alkyl, $(C_6-C_{10})$Aryl, $(C_1-C_3)$Alkoxy, Amino oder Halogen, insbe- |

sondere Chlor

enthalten.

Besonders bevorzugt sind diejenigen Farbstoffe der allgemeinen Formel I, bei denen

| | |
|---|---|
| $R_1$ | Wasserstoff |
| $R_2$ und $R_3$ | Wasserstoff, Hydroxy, $(C_1-C_3)$Alkyl, Phenyl, Amino oder Chlor, insbesondere $R_2$ und/oder $R_3$ Hydroxy, $(C_1-C_3)$Alkyl oder Phenyl bedeuten und diese jeweils bevorzugt in o-Position zur tertiären aromatischen Aminogruppen stehen, sowie |
| $R_4$ und $R_6$ bzw. $R_5$ und $R_7$ | gleich sind und Wasserstoff, $(C_1-C_3)$Alkyl, $(C_1-C_3)$Alkoxy, Amino oder Chlor |

bedeuten.

Insbesondere bevorzugt sind diejenigen Farbstoffe der allgemeinen Formel I, bei denen

| | |
|---|---|
| $R_1$ | Wasserstoff, |
| $R_2$ und $R_3$ | Wasserstoff, Hydroxy oder $(C_1-C_3)$Alkyl, sowie |
| $R_4$ und $R_6$ bzw. $R_5$ und $R_7$ | gleich sind und Wasserstoff oder $(C_1-C_3)$ Alkyl |

bedeuten und hierunter wiederum diejenigen, deren Reste $R_1$ bis $R_7$ einheitlich Wasserstoff sind, sowie diejenigen, deren Reste $R_1$ und $R_3$ bis $R_7$ einheitlich Wasserstoff sind und $R_2$ Methyl ist.

Von diesen Farbstoffen werden solche bevorzugt eingesetzt, deren Absorptionsvermögen möglichst genau der aktinischen Strahlung entsprechen, insbesondere im Bereich der Emission von Quecksilberdampflampen liegen, vor allem bei 365 bis 436 nm und besonders bevorzugt bei Wellenlängen von $\lambda$=365, 405 oder 436 nm. Dadurch wird die zum Erreichen der gewünschten Absorption erforderliche Menge an Farbstoff auf ein Minimum reduziert.

Die Konzentration des absorbierenden Farbstoffes kann von 0,05 bis 2 Gew.-%, besonders bevorzugt von 0,2 bis 0,8 Gew.-%, jeweils bezogen auf die nichtflüchtigen Bestandteile des lichtempfindlichen Gemisches, betragen.

Die jeweils eingesetzte Menge des Farbstoffs hängt naturgemäß von dem molaren Extinktionskoeffizienten des Farbstoffes bei der jeweiligen Belichtungswellenlänge ab. Ist der Gehalt an absorbierendem Farbstoff zu niedrig, dann werden die Reflexionseffekte nur in unzureichender Weise reduziert und keine oder nur eine geringfügige Verbesserung der photolithographischen Eigenschaften erreicht. Andererseits führt eine zu hohe Konzentration an absorbierender Verbindung zu einer Verschlechterung der Bildqualität, da die der Belichtungsquelle näher stehenden Bereiche in der Resistschicht zu stark belichtet werden, während die am Substrat befindlichen Bereiche der Schicht noch nicht ausreichend belichtet sind.

Die Herstellung der im aktinischen Bereich absorbierenden Verbindungen nach Formel I kann nach den in den US-A 2 206 108 und 2 583,551 und der DE-A 31 28 159 beschriebenen Verfahren erfolgen.

Die erfindungsgemäßen lichtempfindlichen Gemische enthalten ferner eine strahlungs- bzw. lichtempfindliche Verbindung oder eine strahlungs- bzw. lichtempfindliche Kombination von Verbindungen. Geeignet sind positiv arbeitende Verbindungen, d.h. solche, die durch Belichten löslich werden. Hierzu gehören einerseits o-Chinondiazide und andererseits Kombinationen von photolytischen Säurespendern mit säurespaltbaren Verbindungen, wie z.B. Orthocarbonsäure- oder Acetalverbindungen.

O-Chinondiazide sind z.B. bekannt aus den DE-C 9 38 233 und 15 43 721, den DE-A 23 31 377, 25 47 905 und 28 28 037. Als o-Chinondiazide werden bevorzugt 1,2-Naphthochinon-2-diazid-4-oder -5-sulfonsäureester oder -amide verwendet. Von diesen werden die Ester, insbesondere die der Sulfonsäuren, besonders bevorzugt. Die Menge an o-Chinondiazidverbindungen im erfindungsgemäßen lichtempfindlichen Gemisch beträgt im allgemeinen 3 bis 50, bevorzugt 7 bis 35 Gew.-%, bezogen auf die nichtflüchtigen Anteile des Gemischs.

Von den säurespaltbaren Materialien werden eingesetzt:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette,

c) Verbindungen mit mindestens einer Enolether- oder N-Acyliminocarbonatgruppierung und

d) cyclische Acetale oder Ketale von ß-Ketoestern oder -amiden.

e) Verbindungen mit Silylethergruppierungen,

f) Verbindungen mit Silylenolethergruppierungen und

g) Monoacetale bzw. Monoketale, deren Aldehyd- bzw. Ketonkomponenten eine Löslichkeit im Entwickler zwischen 0,1 und 100 g/l aufweisen,

h) Ether auf Basis tertiärer Alkohole,

i) Carbonsäureester und Carbonate tertiärer, allylischer oder benzylischer Alkohole.

Durch Säure spaltbare Verbindungen des Typs a) als Komponenten strahlungsempfindlicher Gemische sind in der DE-A-29 28 636 = EP-A-0 022 571, der DE-A-26 10 842 und der US-A 4 101 323 ausführlich beschrieben; Gemische, die Verbindungen des Typs b) enthalten, sind in der DE-C-23 06 248 = US-A 3 779 778 und der DE-C-27 18 254 beschrieben; Verbindungen des Typs c) werden in den EP-A-0 006 626 und 0 006 627 beschrieben, Verbindungen des Typs d) in der EP-A-0 202 196 und Verbindungen, die dem Typ e) zuzurechnen sind, werden in den DE-A-35 44 165 und DE-A-36 01 264 vorgestellt; Verbindungen des Typs f) findet man in der am 13.09.87 eingereichten Patentanmeldung P 37 30 783.5 (Hoe 87/K060), während Verbindungen vom Typ g) in den ebenfalls am 13.09.87 eingereichten Patentanmeldungen P 37 30 785.1 (Hoe 87/K062) und P 37 30 787.8 (Hoe 87/K063) behandelt werden. Verbindungen vom Typ h) werden z.B. in der US-A-4 603 101 beschrieben, Verbindungen vom Typ i) z.B. in der US-A-4 491 628 und von J.M. Fréchet et al., J. Imaging Sci. 30, 59-64 (1986).

Bevorzugte Verbindungen weisen C-O-C-Gruppierungen auf, die durch Säure spaltbar sind.

Von den in der US-A 4 101 323 beschriebenen Orthocarbonsäurederivaten werden besonders die Bis-1,3-dioxan-2-yl-ether von aliphatischen Diolen verwendet. Von den in der DE-C-27 18 254 beschriebenen Polyacetalen werden diejenigen mit aliphatischen Aldehyd- und Dioleinheiten bevorzugt.

Weiter gut geeignete Gemische sind in der EP-A-0 022 571 beschrieben. Dort werden als säurespaltbare Verbindungen polymere Orthoester mit wiederkehrenden Orthoestergruppen in der Hauptkette beschrieben. Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Als licht- bzw. strahlungsempfindliche Säurespender erhalten diese Gemische vorwiegend organische Halogenverbindungen.

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind. Diese können aber auch in Kombination mit anderen Photoinitiatoren wie Oxazolen, Oxadiazolen oder Thiazolen, aber auch untereinander in Mischungen eingesetzt werden.

Es sind aber auch Oxazole, Oxadiazole, Thiazole oder 2-Pyrone bekannt, die Trichlor- oder Tribrommethylgruppen enthalten (DE-A-30 21 599, 30 21 590, 28 51 472, 29 49 396 sowie EP-A-0 135 348 und 0 135 863).

Ebenso zählen unter diesen Oberbegriff insbesondere auch aromatische Verbindungen, die kernständiges Halogen, vorzugsweise Brom aufweisen. Solche Verbindungen sind auch aus der DE-A-26 10 842 bekannt.

Der Mengenanteil der säurespaltbaren Verbindungen in dem erfindungsgemäßen lichtempfindlichen Gemisch liegt im allgemeinen bei 8 bis 65 Gew.-%, vorzugsweise bei 14 bis 44 Gew.-%, bezogen auf die nichtflüchtigen Bestandteile des Gemischs. Die Menge der säurebildenden Verbindungen liegt bei 0,1 bis 10 Gew.-%, vorzugsweise bei 0,2 bis 5 Gew.-%, ebenfalls bezogen auf die nichtflüchtigen Bestandteile des Gemischs.

Die erfindungsgemäßen Beschichtungslösungen enthalten zu-sätzlich zu den vorstehend beschriebenen lichtempfindlichen Bestandteilen polymere Bindemittel. Dabei werden solche Polymeren bevorzugt, die wasserunlöslich und in wäßrig-alkalischen Lösungen löslich, zumindest aber quellbar sind.

Als alkalilösliche, zumindest aber in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, sowie insbesondere Novolake zu nennen.

Als Novolak-Kondensationsharze haben sich besonders die höher kondensierten Harze mit substituierten Phenolen als Formaldehyd-Kondensationspartner bewährt. Genannt werden Phenol-Formaldehydharze, Kresol-Formaldehydharze, deren Mischkondensate und deren Mischungen sowie Phenol- und Kresol-Kondensate mit Formaldehyd.

Statt oder im Gemisch mit Novolaken sind vorteilhaft auch Phenolharze vom Typ des Poly(4-vinylphenols) verwendbar.

Die Art und Menge der alkalilöslichen Harze kann je nach Anwendungszweck verschieden sein; bevorzugt sind Anteile am Gesamtfeststoffgehalt des Gemisches von 30 bis 90 Gew.-%, besonders bevorzugt von 55 bis 85 Gew.-%.

Zusätzlich können noch zahlreiche andere Harze mitverwendet werden, bevorzugt Vinylpolymerisate wie Polyvinylacetate, Poly(meth)acrylate, Polyvinylether, Polyvinylpyrrolidone sowie Styrolpolymerisate, die selbst durch Comonomere modifiziert sein können. Im besonderen sind zu nennen: Polymere von Styrol mit Einheiten von Alkenylsulfonyl-aminocarbonyloxy- oder Cycloalkenylsulfonylaminocarbonyloxy- (EP-A-0 184 804), Polymere der Acryl-, Methacryl-, Malein-, Itaconsäure etc. mit seitenständigen, vernetzenden $-CH_2OR$-Gruppen (EP-A-0 184 044), Polymerisate aus Vinylmonomeren mit Alkenylphenoleinheiten (EP-A-0 153 682), Polyvinylphenole als Novolakersatz (DE-C-23 22 230), polymere Bindemittel mit seitenständigen, phenolischen Hydroxylgruppen (EP-A-0 212 439 und 0 212 440), Styrol-Maleinsäureanhydrid-Mischpolymerisate (DE-A-31 30 987), Polymere aus ungesättigten (Thio)phosphinsäureiso(thio)cyanaten mit einem aktiven Wasserstoff enthaltenden Polymeren (deutsche Patentanmeldungen P 36 15 612.4 und P 36 15 613.2), Polymere mit Vinylacetat-, Vinylalkohol- und Vinylacetaleinheiten (EP-A-0 216 083) sowie Polyvinylacetale mit Einheiten aus Hydroxyaldehyden (deutsche Patentanmeldung P 36 44 162.7).

Der günstigste Anteil dieser Harze im Bindemittel des erfindungsgemäßen lichtempfindlichen Gemischs richtet sich nach den anwendungstechnischen Erfordernissen und dem Einfluß auf die Entwicklungsbedingungen und beträgt im allgemeinen nicht mehr als 20 Gew.-% vom alkalilöslichen Harz.

Ferner können den erfindungsgemäßen lichtempfindlichen Gemischen ggf. Farbstoffe, feinteilige Pigmente, Weichmacher, Netzmittel und Verlaufmittel, aber auch Polyglykole, Cellulosederivate, z.B. Ethylcellulose, zur Verbesserung spezieller Eigenschaften wie Flexibilität, Haftung und Glanz zugesetzt werden.

Ebenso können dem lichtempfindlichen Gemisch übliche vernetzende Substanzen zugesetzt werden. Verbindungen dieser Art werden in der EP-A 0 212 482 genannt.

Vorzugsweise wird das erfindungsgemäße lichtempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatischen Estern wie Ethylacetat, Hydroxyethylacetat, Alkoxyethylacetat, n-Butylacetat, Propylenglykolmonoalkyletheracetat, insbesondere Propylenglykolmethyletheracetat oder Amylacetat; Ethern wie Dioxan, Ketonen wie Methylethylketon, Methyliso-butylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran, und in Mischungen derselben gelöst. Besonders bevorzugt werden Glykolether, aliphatische Ester sowie Ketone.

Der Gesamtfeststoffgehalt des erfindungsgemäßen Gemisches liegt je nach Art der lichtempfindlichen Verbindungen und der Bindemittel sowie je nach Verwendungszweck im allgemeinen bei 10 bis 50 Gew.-%, vorzugsweise bei 15 bis 35 Gew.-%.

Erfindungsgemäß wird ferner ein lichtempfindliches Aufzeichnungsmaterial beansprucht, im wesentlichen bestehend aus einem Substrat und dem darauf aufgetragenen lichtempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus thermisch oxidiertem und/oder mit Aluminium beschich-tetem Siliciummaterial zu nennen, die gegebenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete $SiO_2$-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das lichtempfindliche Material, zur besseren Haftung des Resists im Resist gelöst oder zwischen dem Resist und dem Substrat aufgebracht, einen Haftvermittler enthalten. Bei Silicium- bzw. Siliciumdioxid-Substraten kommen hierfür Haftvermittler vom Aminosilan-Typ, wie z.B. 3-Aminopropyltriethoxysilan oder Hexamethyl-disilazan in Frage.

Beispiele für Träger, die zur Herstellung von photomechanischen Aufzeichnungsmaterialien wie Druckformen für den Hochdruck, den Flachdruck, den Siebdruck, den Tiefdruck sowie von Reliefkopien Verwendung finden können, sind Aluminiumplatten, ggf. anodisch oxidiert, gekörnte und/oder silikatisierte Aluminiumplatten, Zinkplatten, Stahlplatten, die ggf. mit Chrom beschichtet wurden, sowie Kunststoffolien oder Papier.

Das lichtempfindliche Gemisch kann in üblicher Weise, wie z.B. durch Tauchen, Gießen, Schleudern, Sprühen, mittels Walzen oder durch Schlitzdüsen auf den zu beschichtenden Träger aufgebracht werden.

Die erfindungsgemäßen Aufzeichnungsmaterialien werden bildmäßig belichtet. Quellen aktinischen Lichts sind: Metallhalogenidlampen, Kohlebogenlampen, Xenonlampen und Quecksilberdampflampen, deren Emissionsmaxima im nahen UV- oder kurzwelligen sichtbaren Licht liegen. Die Bebilderung kann auch mit Elektronen-, Röntgen- oder Laserstrahlung erfolgen. Als Laser werden insbesondere Helium/Neon-Laser, Argon-Laser, Krypton-Laser sowie Helium/Cadmium-Laser genannt.

Nach einem eventuellen Erhitzen des Aufzeichnungsmaterials kann die Schicht, sofern sie einen Vernetzer enthält, zum Erreichen einer Bildumkehr mit aktinischer Strahlung ganzflächig nachbelichtet werden.

Die Schichtstärke der lichtempfindlichen Schicht variiert in Abhängigkeit von ihrem Einsatzgebiet. Sie beträgt zwischen 0,1 und 100 $\mu m$, insbesondere zwischen 1 und 10 $\mu m$.

Die zum Entwickeln verwendeten wäßrig-alkalischen Lösungen abgestufter Alkalität, d.h. mit einem pH-Wert, der bevorzugt bei 10 bis 14 liegt, und die auch kleinere Mengen organischer Lösungs- oder Netzmittel enthalten können, entfernen die belichteten Stellen der Kopierschicht und erzeugen so ein positives Abbild der Vorlage.

Die folgenden Beispiele beschreiben bevorzugte Ausführungsformen der Erfindung. Mengenverhältnisse und Prozentzahlen sind, wenn nichts anderes angegeben ist, mit Gewichtseinheiten zu versehen.

Beispiel 1:

Ein lichtempfindliches Gemisch bestehend aus

| | |
|---|---|
| 7,0 Gt | des Veresterungsproduktes aus 1 mol 2,3,4-Trihydroxybenzophenon und 2 mol 1,2-Naphthochinondiazid-5-sulfonylchlorid, |
| 23,0 Gt | eines Poly-p-vinylphenols mit einer Glasübergangstemperatur von 165°C, |
| 0,8 Gt | 4-Bis-(2-hydroxyethyl)aminophenylmethylenpropandinitril, |
| 28,0 Gt | Ethylenglykolmonoethyletheracetat, |
| 3,5 Gt | n-Butylacetat und |
| 3,5 Gt | Xylol |

wurde mit 4.000 Umdrehungen pro Minute auf einen Siliciumwafer aufgeschleudert und in einem Umluftofen bei 90° C für 30 Minuten getrocknet. Die 2,03 µm dicke Schicht wurde mit aktinischer Strahlung der Wellenlänge λ=436 nm an 8 verschiedenen Stellen mit Energien von 31,4 bis 169 mJ/cm² belichtet. Entwickelt wurde in einer Lösung aus

| | |
|---|---|
| 0,61 Gt | Natriummetasilikat x 9 $H_2O$ |
| 0,46 Gt | Trinatriumphosphat x 12 $H_2O$ |
| 0,04 Gt | Mononatriumphosphat, wasserfrei in |
| 98,89 Gt | entionisierten Wasser. |

Nach einer Entwicklungszeit von 60 Sekunden bei 21° C waren von der Fläche, die mit 104,8 mJ/cm² belichtet wurde, 1 µm Resistdicke abgelöst.

Beispiel 2 (Vergleichsbeispiel):

Ein lichtempfindliches Gemisch bestehend aus

| | |
|---|---|
| 7,0 Gt | des Veresterungsproduktes aus 1 mol 2,3,4-Trihydroxybenzophenon und 2 mol 1,2-Naphtochinondiazid-5-sulfonylchlorid, |
| 23,0 Gt | eines Poly-p-vinylphenols mit einer Glasübergangstemperatur von 165° C, |
| 1,07 Gt | Cumarin 338 (äquimolare Menge zu der in Beispiel 1 genannten absorbierenden Verbindung) |
| 28,0 Gt | Ethylenglykolmonoethyletheracetat, |
| 3,5 Gt | n-Butylacetat und |
| 3,5 Gt | Xylol |

wurde mit 4.000 Umdrehungen pro Minute auf einen Siliciumwafer aufgeschleudert und in einem Umluftofen bei 90° C für 30 Minuten getrocknet. Die 2,13 µm dicke Schicht wurde mit aktinischer Strahlung der Wellenlänge λ=436 nm an 8 verschiedenen Stellen mit Energien von 50,7 bis 273 mJ/cm² belichtet. Entwickelt wurde in einer Lösung aus

| | |
|---|---|
| 0,61 Gt | Natriummetasilikat x 9 $H_2O$ |
| 0,46 Gt | Trinatriumphosphat x 12 $H_2O$ |
| 0,04 Gt | Mononatriumphosphat, wasserfrei in |
| 98,89 Gt | entionisiertem Wasser. |

Nach einer Entwicklungszeit von 60 Sekunden bei 21° C waren von der Fläche, die mit 198 mJ/cm² belichtet wurde, 1 µm Resistdicke abgelöst.

Beispiel 3 (Vergleichsbeispiel):

Ein lichtempfindliches Gemisch bestehend aus

| | |
|---|---|
| 7,0 Gt | des Veresterungsproduktes aus 1 mol 2,3,4-Trihydroxybenzophenon und 2 mol 1,2-Naphthochinondiazid-5-sulfonylchlorid, |
| 23,0 Gt | eines Poly-p-vinylphenols mit einer Glasübergangstemperatur von 165° C, |
| 28,0 Gt | Ethylenglykolmonoethyletheracetat, |
| 3,5 Gt | n-Butylacetat und |
| 3,5 Gt | Xylol |

wurde mit 4.000 Umdrehungen pro Minute auf einen Siliciumwafer aufgeschleudert und in einem Umluftofen

bei 90° C für 30 Minuten getrocknet. Die 2,05 µm dicke Schicht wurde mit aktinischer Strahlung der Wellenlänge λ=436 nm an 8 verschiedenen Stellen mit Energien von 25 bis 136 mJ/cm² belichtet. Entwickelt wurde in einer Lösung aus

| | |
|---|---|
| 0,61 Gt | Natriummetasilikat x 9 $H_2O$ |
| 0,46 Gt | Trinatriumphosphat x 12 $H_2O$ |
| 0,04 Gt | Mononatriumphosphat, wasserfrei in |
| 98,89 Gt | entionisiertem Wasser. |

Nach einer Entwicklungszeit von 60 Sekunden bei 21° C waren von der Fläche, die mit 53 mJ/cm² belichtet wurde, 1 µm Resistdicke abgelöst.

Ein Vergleich der Beispiele 1 bis 3 zeigt, daß unter der Voraussetzung vergleichbarer Auflösung die Lichtempfindlichkeit einer Photoresistformulierung mit einer absorbierenden Verbindung nach Formel I (Beispiel 1) um nur 97 % gegenüber dem Resist ohne Zusatz (Beispiel 3) abnimmt, während der Zusatz von äquimolaren Mengen an Cumarin 338 (Beispiel 2) die praktische Lichtempfindlichkeit um 273 % verringert.

Beispiel 4:

Ein lichtempfindliches Gemisch bestehend aus

| | |
|---|---|
| 3,0 Gt | Bis-(5-ethyl-5-butyl-1,3-dioxan-2-yl)-ether des 2-Ethyl-butyl-propan-1,3-diols, |
| 10,0 Gt | eines Kresol-Formaldehyd Novolaks mit einem Schmelzbereich von 147 - 150° C, |
| 0,5 Gt | 2-(4-Ethoxynaphth-1-yl)-4,6-bis-trichlormethyl-s-triazin, |
| 0,08 Gt | 4-Bis-(2-hydroxyethyl)aminophenylmethylenpropandinitril und |
| 35,0 Gt | Propylenglykolmonomethyletheracetat |

wurde mit 4.000 Umdrehungen pro Minute auf einen Siliciumwafer aufgeschleudert und in einem Umluftofen bei 90° C für 30 Minuten getrocknet. Die 0,93 µm dicke Schicht wurde mit aktinischer Strahlung der Wellenlänge λ=436 nm an 8 verschiedenen Stellen mit Energien von 24,3 bis 131 mJ/cm² belichtet. Entwickelt wurde in 1 %iger wäßriger Natronlauge. Bei einer Belichtungsenergie von 59,0 mJ/cm² war das Substrat nach 60 Sekunden bei 21° C frei entwickelt.

Beispiel 5 (Vergleichsbeispiel):

Ein lichtempfindliches Gemisch bestehend aus

| | |
|---|---|
| 3,0 Gt | Bis-(5-ethyl-5-butyl-1,3-dioxan-2-yl)-ether des 2-Ethyl-butyl-propan-1,3-diols, |
| 10,0 Gt | eines Kresol-Formaldehyd Novolaks mit einem Schmelzbereich von 147 - 150° C, |
| 0,5 Gt | 2-(4-Ethoxynaphth-1-yl)-4,6-bis-trichlormethyl-s-triazin, |
| 0,107 Gt | Cumarin 338 und |
| 35,0 Gt | Propylenglykolmonoethyletheracetat |

wurde mit 4.000 Umdrehungen pro Minute auf einen Siliciumwafer aufgeschleudert und in einem Umluftofen bei 90° C für 30 Minuten getrocknet. Die 0,94 µm dicke Schicht wurde mit aktinischer Strahlung der Wellenlänge λ=436 nm an 8 verschiedenen Stellen mit Energien von 24,3 bis 131 mJ/cm² belichtet. Entwickelt wurde in 1 %iger wäßriger Natronlauge. Bei einer Belichtungsenergie von 131,0 mJ/cm² war das Substrat nach 60 Sekunden bei 21° C frei entwickelt.

Beispiel 6 (Vergleichsbeispiel):

Ein lichtempfindliches Gemisch bestehend aus

| | |
|---|---|
| 3,0 Gt | Bis-(5-ethyl-5-butyl-1,3-dioxan-2yl)-ether des 2-Ethyl-butyl-propan-1,3-diols, |
| 10,0 Gt | eines Kresol-Formaldehyd Novolaks mit einem Schmelzbereich von 147 - 150° C, |
| 0,5 Gt | 2-(4-Ethoxynaphth-1-yl)-4,6-bis-trichlormethyl-s-triazin, |
| 35,0 Gt | Propylenglykolmonomethyletheracetat |

wurde mit 4.000 Umdrehungen pro Minute auf einen Siliciumwafer aufgeschleudert und in einem Umluftofen bei 90° C für 30 Minuten getrocknet. Die 0,94 µm dicke Schicht wurde mit aktinischer Strahlung der Wellenlänge λ=436 nm an 8 verschiedenen Stellen mit Energien von 24,3 bis 131 mJ/cm² belichtet. Entwickelt wurde in 1 %iger wäßriger Natronlauge. Bei einer Belichtungsenergie von 36,3 mJ/cm² war das Substrat nach 60 Sekunden bei 21° C frei entwickelt.

Ein Vergleich der Beispiele 4 bis 6 zeigt, daß unter der Voraussetzung gleicher Auflösung die Lichtempfindlichkeit einer Photoresistformulierung mit einer absorbierenden Verbindung nach Formel I (Beispiel 4) um nur 62 % gegenüber dem Resist ohne Zusatz (Beispiel 6) abnimmt, während der Zusatz von äquimolaren Mengen an Cumarin 338 (Beispiel 5) die praktische Lichtempfindlichkeit um 261 % verringert.

Beispiele 7 bis 15:

Ein lichtempfindliches Gemisch bestehend aus

3,5 Gt des Veresterungsproduktes aus 1 mol 2,3,4-Trihydroxybenzophenon und 2 mol 1,2-Naphthochinondiazid-5-sulfonylchlorid,
11,9 Gt eines Kresol-Formaldehyd-Novolaks mit einem Schmelzbereich von 147 - 150° C,
27,2 Gt Ethylenglykolmonoethyletheracetat,
3,45 Gt n-Butylacetat und
3,45 Gt Xylol

wurde jeweils mit einer der in Tabelle 1 angegebenen absorbierenden Substanzen versetzt und zu einer homogenen Lösung vermischt. Diese Lösung wurde mit 4.000 Umdrehungen auf einem Siliciumwafer aufgeschleudert und in einem Umluftofen bei 90° C für 30 Minuten getrocknet. Die Schichten mit einer Dicke von etwa 1,8 µm wurden an 8 verschiedenen Stellen mit aktinischer Strahlung von λ=436 nm und unterscheidlichen Belichtungszeiten belich tet. Anschließend wurden die Wafer in einer 0,27 n wäßrigen Lösung von Tetramethylammoniumhydroxid entwickelt. Nach einer Belichtungszeit von 60 Sekunden bei 21° C wurden die Resistschichtdicken an den unterschiedlich belichteten Bereichen gemessen und der Energiewert bestimmt, der zum Ablösen einer 1 µm dicken Resistschicht erforderlich ist.

Tabelle 1:

| Beispiel Nr. | Zusatz an absorbierenden Verbindungen | Energie zum Ablösen von 1 µm Resistschicht |
|---|---|---|
| 7 (V) | ohne Zusatz | 42,8 mJ/cm$^2$ |
| 8 (V) | 0,1006 g Cumarin 338 | 49,8 mJ/cm$^2$ |
| 9 (V) | 0,0978 g Cumarin 314 | 49,2 mJ/cm$^2$ |
| 10 (V) | 0,1041 g Cumarin 7 | 62,4 mJ/cm$^2$ |
| 11 | 0,0803 g 4-Bis-(2-hydroxyethyl)-aminophenylmethylenpropandinitril | 43,6 mJ/cm$^2$ |
| 12 (V) | 0,1241 g 4-Bis-(2-isopropylcarbonyl-oxyethyl)-aminophenylmethylen-propandinitril | 60,5 mJ/cm$^2$ |
| 13 (V) | 0,1327 g 4-Bis-(2-tert-butylcarbonyl-oxyethyl)-aminophenylmethylen-propandinitril | 59,1 mJ/cm$^2$ |
| 14 (V) | 0,0753 g 4-(2-hydroxyethyl)-4'-ethyl-aminophenyl-methylenpropandinitril | 48,3 mJ/cm$^2$ |
| 15 (V) | 0,084 g 4-(2-hydroxyethyl-n-butyl)-aminophenyl-methylen-propandinitril | 58,9 mJ/cm$^2$ |

Ein Vergleich der Energiewerte zeigt, daß die geringste Energie zum Ablösen der Resistschicht mit einem Farbstoff nach Formel I (Beispiel 11) benötigt wird.

Beispiel 16:

Ein lichtempfindliches Gemisch bestehend aus

| | |
|---|---|
| 6,0 Gt | des Veresterungsproduktes aus 1 mol 2,3,4-Trihydroxybenzophenon und 3 mol 1,2-Naphthochinondiazid-4-sulfonylchlorid, |
| 89,0 Gt | eines Kresol-Formaldehyd-Novolaks mit einem Schmelzbereich von 147-150° C, |
| 5,0 Gt | Hexamethylol-melamin-hexamethylether, |
| 2,0 Gt | Bis-(2-hydroxyethyl)-aminophenylmethylenpropandinitril und |
| 370,0 Gt | Propylenglykolmonomethyletheracetat |

wurde mit 4.000 Umrehungen pro Minute auf einen Siliciumwafer aufgeschleudert und auf einer Hotplate bei 90° C für 1 Minute getrocknet. Die Schicht mit einer Dicke von 1,4 µm wurde an 8 verschiedenen Stellen mit aktinischer Strahlung von $\lambda$=436 nm belichtet und anschließend mit folgender Lösung entwickelt:

| | |
|---|---|
| 2,25 Gt | Natriummetasilikat x 9 $H_2O$ |
| 1,7 Gt | Trinatriumphosphat x 12 $H_2O$ |
| 0,15 Gt | Mononatriumphosphat, wasserfrei und |
| 95,80 Gt | entionisiertes Wasser. |

Nach einer Entwicklungszeit von 60 Sekunden bei 21° C war die mit 160 mJ/cm² belichtete Resistschicht bis zum Substrat frei entwickelt.

Ein zweiter Siliciumwafer wurde in gleicher Weise beschichtet, vorgetrocknet und belichtet. Anschließend wurde er für 60 Sekunden auf 120° C erhitzt und danach mit aktinischer Strahlung von 200 mJ/cm² ganzflächig belichtet. Die gewünschte Vernetzung der erstbelichteten Bereiche wurde bei einer Belichtungsenergie von 90 mJ/cm² erreicht.

Beispiel 17 (Vergleichsbeispiel):

Ein lichtempfindliches Gemisch analog zu Beispiel 16, jedoch ohne den Zusatz an Bis-(2-hydroxyethyl)aminophenylmethylenpropandinitril wurde wie in Beispiel 16 verarbeitet.

Zur vollständigen Aufentwicklung der Resistschicht war eine Belichtungsenergie von 125 mJ/cm² ausreichend.

Die gewünschte Vernetzung der Resistschicht wurde bei einer Belichtungsenergie von 75 mJ/cm² beobachtet.

Ein Vergleich der Beispiele 16 und 17 zeigt, daß die Lichtempfindlichkeit durch den Zusatz an Farbstoff nach Formel I um nur 28 % (für Erzeugung von Positivresiststrukturen) bzw. 20 % (für Erzeugung von Negativresiststrukturen) abnimmt.

**Patentansprüche**

**1.** Positiv arbeitendes lichtempfindliches Gemisch, enthaltend eine lichtempfindliche Verbindung, ein wasserunlösliches, in wäßrig-alkalischer Lösung aber lösliches bzw. quellbares Bindemittel sowie einen Farbstoff, dadurch gekennzeichnet, daß der Farbstoff eine im aktinischen Bereich absorbierende, nicht ausbleichbare Verbindung der allgemeinen Formel I

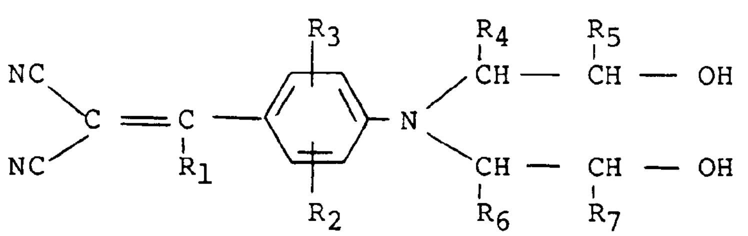

(I)

ist, worin

| | |
|---|---|
| $R_1$ | Wasserstoff, Alkyl, Aryl, Alkoxy oder Nitrilo, |
| $R_2$ und $R_3$ | gleich oder verschieden sind und Wasserstoff, Hydroxy, Alkyl, Aryl, Alkoxy, Aryloxy, Nitrilo, Amino, Alkylamino oder Halogen, |
| $R_4$, $R_5$, $R_6$ und $R_7$ | gleich oder verschieden sind und Wasserstoff, Hydroxy, Alkyl, Aryl, Alkoxy, |

Aryloxy, Amino, Alkylamino oder Halogen

bedeuten.

2. Lichtempfindliches Gemisch nach Anspruch 1, dadurch gekennzeichnet, daß der Farbstoff ein Absorptionsmaximum besitzt, welches im Bereich der Emission von Quecksilberdampflampen liegt.

3. Lichtempfindliches Gemisch nach den Ansprüchen 1 oder 2, dadurch gekennzeichnet, daß der Farbstoff ein Absorptionsmaximum im Bereich von 365 bis 436 nm aufweist.

4. Lichtempfindliches Gemisch nach einem oder mehreren der Ansprüche 1 bis 3, dadurch gekennzeichnet, daß als lichtempfindliche Verbindung ein o-Chinondiazid enthalten ist.

5. Lichtempfindliches Gemisch nach einem oder mehreren der Ansprüche 1 bis 3, dadurch gekennzeichnet, daß als lichtempfindliche Verbindung ein photolytischer Säurespender in Kombination mit einer säurespaltbaren Verbindung mit einer C-O-C Gruppierung enthalten ist.

6. Lichtempfindliches Gemisch nach Anspruch 5, dadurch gekennzeichnet, daß als photolytischer Säurespender eine organische Halogenverbindung enthalten ist.

7. Lichtempfindliches Gemisch nach einem oder mehreren der Ansprüche 1 bis 6, dadurch gekennzeichnet, daß als Bindemittel ein Novolak-Kondensationsharz enthalten ist.

8. Lichtempfindliches Gemisch nach Anspruch 7, dadurch gekennzeichnet, daß das alkalilösliche Novolak-Kondensa tionsharz mit bis zu 20 Gew.-% anderer Harze verschnitten ist.

9. Lichtempfindliches Gemisch nach einem oder mehreren der Ansprüche 1 bis 8, dadurch gekennzeichnet, daß es einen Vernetzer enthält.

10. Verfahren zur Herstellung eines Reliefmusters nach dem Bildumkehrverfahren, im wesentlichen bestehend aus dem Aufbringen eines lichtempfindlichen Gemisches nach Anspruch 9 auf einen Träger, dem Trocknen der Schicht, bildmäßigem Belichten und gegebenenfalls einem Nacherhitzen, dadurch gekennzeichnet, daß mit aktinischer Strahlung ganzflächig nachbelichtet wird.

11. Positiv arbeitendes lichtempfindliches Aufzeichnungsmaterial, im wesentlichen bestehend aus einem Träger und einer lichtempfindlichen Schicht, dadurch gekennzeichnet, daß dieses als lichtempfindliche Schicht ein Gemisch entsprechend den Ansprüchen 1 bis 9 enthält.

## Claims

1. Positive-working photosensitive composition comprising a photosensitive compound, a binder that is insoluble in water and soluble or swellable in an aqueous-alkaline solution, and a dye, characterized in that the dye comprises a non-bleachable compound which absorbs light in the actinic region and corresponds to the general formula I

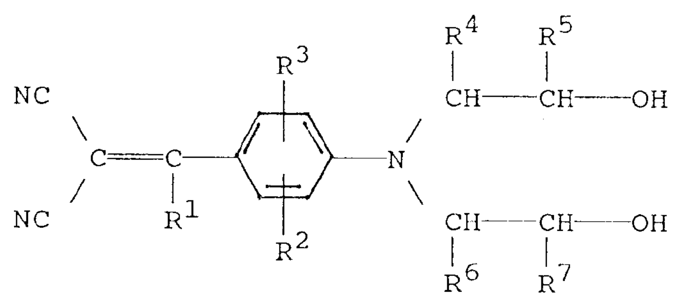

(I)

wherein

| | |
|---|---|
| $R^1$ | denotes hydrogen, alkyl, aryl, alkoxy or nitrilo, |
| $R^2$ and $R^3$ | are identical or different and denote hydrogen, hydroxy, alkyl, aryl, alkoxy, ar- |

yloxy, nitrilo, amino, alkylamino or halogen,

$R^4$, $R^5$ $R^6$ and $R^7$ are identical or different and denote hydro gen, hydroxy, alkyl, aryl, alkoxy, aryloxy, amino, alkylamino or halogen.

2. A photosensitive composition as claimed in claim 1, characterized in that the dye has an absorption peak which is in the range of the emission of mercury vapor lamps.

3. A photosensitive composition as claimed in claim 1, characterized in that the dye has an absorption peak in the region from 365 to 436 nm.

4. A photosensitive composition as claimed in any one or several of claims 1 to 3, characterized in that an o-quinone diazide is present as the photosensitive compound.

5. A photosensitive composition as claimed in any one or several of claims 1 to 3, characterized in that a photolytic acid donor in combination with an acid-cleavable compound containing a C-O-C group is present as the photosensitive compound.

6. A photosensitive composition as claimed in claim 5, characterized in that an organic halogen compound is present as the photolytic acid donor.

7. A photosensitive composition as claimed in any one or several of claims 1 to 6, characterized in that a novolak condensation resin is present as the binder.

8. A photosensitive composition as claimed in claim 7, characterized in that the alkali-soluble novolak condensation resin is blended with other resins in a proportion of up to 20 % by weight.

9. A photosensitive composition as claimed in any one or several of claims 1 to 8, characterized in that the photosensitive composition comprises a crosslinking agent.

10. A process for the production of a relief pattern according to the image reversal process, the process essentially comprising the steps of coating a support with the photosensitive composition as claimed in claim 9, drying, imagwise exposing and optionally post-baking the layer, characterized in that an overall reexposure is carried out by means of actinic radiation.

11. Positive-working photosensitive recording material essentially comprising a support and a photosensitive layer, characterized in that the material comprises a composition as claimed in claims 1 to 9 as the photosensitive layer.

## Revendications

1. Composition photosensible travaillant en positif, contenant un composé photosensible, un liant insoluble dans l'eau, mais soluble ou susceptible de gonfler dans une solution aqueuse-alcaline, ainsi qu'un colorant, caractérisée en ce que le colorant est un composé non sujet à la décoloration, absorbant dans la région actinique, de formule générale I

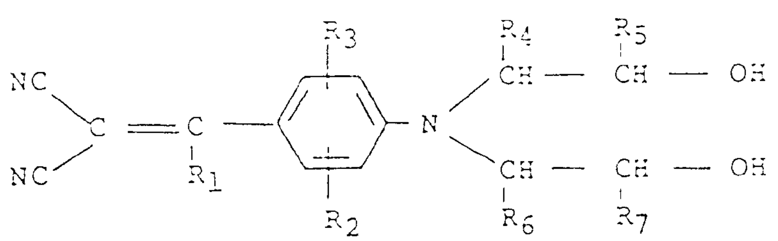

(I)

dans laquelle

$R_1$ représente un atome d'hydrogène ou un groupe alkyle, aryle, alcoxy ou nitrilo,

$R_2$ et $R_3$ sont identiques ou différents et représentent un atome d'hydrogène ou d'halogène ou un groupe hydroxy, alkyle, aryle, alcoxy, aryloxy, nitrilo, amino ou

| | |
|---|---|
| | alkylamino, |
| $R_4$, $R_5$, $R_6$ et $R_7$ | sont identiques ou différents et représentent un atome d'hydrogène ou d'halogène ou un groupe hydroxy, alkyle, aryle, alcoxy, aryloxy, amino ou alkylamino. |

**2.** Composition photosensible selon la revendication 1, caractérisée en ce que le colorant présente un maximum d'absorption qui se situe dans la plage de l'émission de lampes à vapeur de mercure.

**3.** Composition photosensible selon la revendication 1 ou 2, caractérisée en ce que le colorant présente un maximum d'absorption dans la plage de 365 à 436 nm.

**4.** Composition photosensible selon une ou plusieurs des revendications 1 à 3, caractérisée en ce qu'un o-quinonediazide est contenu en tant que composé photosensible.

**5.** Composition photosensible selon une ou plusieurs des revendications 1 à 3, caractérisée en ce qu'elle contient, en tant que composé photosensible, un donneur photolytique d'acide en association avec un composé dissociable par un acide, comportant un groupement C-O-C.

**6.** Composition photosensible selon la revendication 5, caractérisée en ce qu'un composé organique halogéné est contenu en tant que donneur photolytique d'acide.

**7.** Composition photosensible selon une ou plusieurs des revendications 1 à 6, caractérisée en ce qu'une résine de condensation de type Novolaque est contenue en tant que liant.

**8.** Composition photosensible selon la revendication 7, caractérisée en ce que la résine de condensation de type Novolaque, soluble dans les alcalis, est mélangée avec jusqu'à 20 % en poids d'autres résines.

**9.** Composition photosensible selon une ou plusieurs des revendications 1 à 8, caractérisée en ce qu'elle contient un agent de réticulation.

**10.** Procédé pour la production d'un motif en relief selon le procédé d'inversion d'image, consistant essentiellement en l'application sur un support d'une composition photosensible selon la revendication 9, le séchage de la couche, l'insolation selon l'image et éventuellement un post-chauffage, caractérisé en ce que l'on effectue une postinsolation de toute la surface avec un rayonnement actinique.

**11.** Matériau de reprographie photosensible travaillant en positif, essentiellement constitué d'un support et d'une couche photosensible, caractérisé en ce qu'il contient, en tant que couche photosensible, une composition selon les revendications 1 à 9.